# EUROPÄISCHE PATENTSCHRIFT

(11) **EP 4 346 043 B1**
(45) Veröffentlichungstag und Bekanntmachung des Hinweises auf die Patenterteilung: **29.07.2026**
(21) Anmeldenummer: 23210103.0
(22) Anmeldetag: 26.06.2018
(51) Int. Cl.: H02H 3/17, G01R 27/18, H02H 7/12, H02H 3/16, G01R 31/12

(54) **VERFAHREN, ELEKTRISCHE SCHALTUNGSANORDNUNGEN UND ISOLATIONSÜBERWACHUNGSGERÄTE FÜR EINE STÖRRESISTENTE ISOLATIONSÜBERWACHUNG EINES UNGEERDETEN STROMVERSORGUNGSSYSTEM MIT EINEM UMRICHTER**
METHOD, ELECTRICAL CIRCUIT ARRANGEMENTS AND INSULATION MONITORING DEVICES FOR INTERFERENCE-RESISTANT INSULATION MONITORING OF AN UNEARTHED POWER SUPPLY SYSTEM WITH A CONVERTER
PROCÉDÉS, CIRCUITS ÉLECTRIQUES ET DISPOSITIFS DE SURVEILLANCE D'ISOLATION POUR UNE SURVEILLANCE D'ISOLATION RÉSISTANTE AUX PERTURBATIONS D'UN SYSTÈME D'ALIMENTATION ÉLECTRIQUE NON MIS À LA TERRE COMPRENANT UN CONVERTISSEUR

(30) Priorität: 11.07.2017 DE 102017211845
(43) Veröffentlichungstag der Anmeldung: 03.04.2024
(62) Teilanmeldung aus: 18179958.6
(73) Patentinhaber: Bender GmbH & Co. KG, 35305 Grünberg (DE)
(72) Erfinder: HACKL, Dieter, 35463 Fernwald (DE)
(74) Vertreter: advotec.

(56) Entgegenhaltungen:
- EP-A1- 2 219 041
- EP-A1- 2 230 522
- EP-A1- 2 530 801
- EP-A2- 1 229 629
- EP-A2- 2 490 032

## Beschreibung

Die Erfindung betrifft ein Verfahren und eine elektrische Schaltungsanordnung für eine störresistente Isolationsüberwachung eines ungeerdeten Stromversorgungssystems mit einem Umrichter (Frequenzumrichter).

Weiterhin betrifft die Erfindung ein Isolationsüberwachungsgerät mit der vorgeschlagenen elektrischen Schaltungsanordnung.

Für die Versorgung von elektrischen Betriebsmitteln kommt bei erhöhten Anforderungen an die Betriebs-, Brand- und Berührungssicherheit die Netzform eines ungeerdeten (IT-) Stromversorgungssystems (frz. Isolé Terre) zum Einsatz. Bei dieser Art des Stromversorgungssystems sind alle aktiven Teile des versorgenden Netzes von dem Erdpotential getrennt.

Durch die inhärente Sicherheit des ungeerdeten Stromversorgungssystems gegenüber gefährlichen Berührungsspannungen kann somit eine kontinuierliche Stromversorgung der an das ungeerdete Stromversorgungssystem angeschlossenen Verbraucher auch dann aufrechterhalten werden, wenn ein erster Isolationsfehler auftritt.

Der elektrische Widerstand von aktiven Leitern des Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

In der Regel erfolgt die Überwachung des Isolationswiderstands durch ein Isolationsüberwachungsgerät (IMD - Insulation Monitoring Device), welches dem Stromversorgungssystem aktiv eine Messspannung überlagert und ein dem Isolationswiderstand entsprechendes Messsignal erfasst und auswertet.

Allerdings existieren in dem ungeerdeten Stromversorgungssystem Anwendungsfälle, beispielsweise im Bergbau oder in Kraftwerken, in denen auch bei Auftreten eines ersten Isolationsfehlers die Stromversorgung möglichst schnell abgeschaltet werden soll. Das Isolationsüberwachungsgerät sollte dann möglichst schnell einen ersten Fehler erkennen und ein Schaltsignal auslösen.

Die Forderung nach einer möglichst kurzen Abschaltzeit wird, anders als in einem geerdeten Stromversorgungssystem, nicht mit dem Ziel einer Vermeidung der Gefährdung durch elektrischen Schlag bestimmt - diese Gefährdung existiert in dem normgerecht installierten ungeerdeten Stromversorgungssystem definitionsgemäß im ersten Fehlerfall nicht -, sondern durch die Anforderungen im Hinblick auf den Brandschutz und den Anlagenschutz.

Insbesondere bei der Isolationsüberwachung in Verbindung mit hochwertigen (Frequenz-) Umrichtern und geregelten Antrieben wären mit einer aktiven Isolationsüberwachung kurze Abschaltzeiten im Bereich von einigen 10 s theoretisch möglich, da die Netzableitkapazitäten in diesen Antrieben häufig genügend kleine Werte aufweisen.

Praktisch sind diese Abschaltzeiten in vielen Umrichteranwendungen aber nicht erreichbar, da gerade durch den Umrichterantrieb (Umrichtergeregelter Elektromotormotor) applikationsbedingt niederfrequente Verlagerungsspannungen, d.h. Spannungen zwischen einem aktiven Leiter und Erde, mit einer Amplitude erzeugt werden, die häufig ein Vielfaches der Amplitude der von dem Isolationsüberwachungsgerät angelegten Messspannung beträgt und damit das erfasste Messsignal empfindlich stören können.

Liegt zudem die Frequenz der niederfrequenten Verlagerungsspannungsanteile sehr nahe bei der (Grund-) Frequenz (Messfrequenz) der angelegten und speziell getakteten Messspannung, so ist eine Überwachung in diesem Betriebszustand nicht möglich.

Herstellerübergreifend wird dem Störeinfluss durch niederfrequente Verlagerungsspannungsanteile in technischen Dokumentationen der Isolationsüberwachungsgeräte mit der Angabe einer (Überwachungs-) Lücke im spezifizierten Frequenzbereich Rechnung getragen. So ist beispielsweise der überwachbare Frequenzbereich bei einem dem Stand der Technik entsprechenden Isolationsüberwachungsgerät dahingehend spezifiziert, dass eine zuverlässige Isolationsüberwachung nur für Netzspannungen "DC und 15 bis 460 Hz" möglich ist, also eine Überwachungslücke zwischen DC (Gleichstrom) und 15 Hz existiert.

Aufgrund der niederfrequenten Störanteile in dem erfassten Messsignal gestaltet sich die Auswertung des erfassten Messsignals aufwändig und die nach dem Stand der Technik erreichbaren Abschaltzeiten sind deutlich höher, als dies in manchen kritischen Anwendungen (Bergbau, Kraftwerke) gefordert wird.

Extreme Anforderungen an die Abschaltzeiten treten insbesondere dann auf, wenn beispielsweise ein bestehendes 3AC 50/60 Hz IT-System mit sehr großen Netzableitkapazitäten mit einem leistungsstarken Frequenzumrichter-Antrieb erweitert wird. So können bei einem Erdschluss an einer Motorphase des geregelten Umrichterantriebs Verlagerungsspannungen entstehen, die zur Zerstörung von nicht dafür ausgelegten Betriebsmitteln im bestehenden 3AC 50/60 Hz IT-System führt. Hier werden oft Abschaltzeiten unter 100 ms gefordert.

Neben niederfrequenten Störungen, die eine rechenintensive und zeitaufwändige Auswertung des erfassten Messsignals erfordern und damit eine Schnellabschaltung beeinträchtigen, treten auch vom Umrichter erzeugte, schaltfrequente, d.h. der Schaltfrequenz des Umrichters entsprechende, Störanteile im Bereich von ca. 10 kHz oder darüber auf, die wegen ihrer beeinträchtigenden Wirkung auf die Betriebsmittel eine schnelle Abschaltung der Stromversorgung erforderlich machen.

Zur Isolationsüberwachung ist aus dem Stand der Technik bekannt, den Messspannungsanteil aus dem störungsbehafteten, erfassten Messsignal durch analoge oder digitale Filtermaßnahmen zu selektieren.

In der Regel kommen in hochwertigen Isolationsüberwachungsgeräten aufwändige Methoden der digitalen Signalverarbeitung zum Einsatz, um Störkomponenten zu unterdrücken, deren Frequenz sehr nahe bei der Messfrequenz liegt. Je näher die Störsignalfrequenz bei der Messfrequenz liegt, umso mehr Rechenaufwand und Verarbeitungszeit wird für eine ausreichende Störsignalunterdrückung benötigt.

Ein in geerdeten - im Vergleich zu den hier betrachteten ungeerdeten - Stromversorgungssystemen verfolgter Ansatz, eine Schnellabschaltung von Anlagenteilen im Fall eines kritischen Fehlers zu realisieren, besteht darin, Differenzstrom-basierte Schutzeinrichtungen (Fehlerstrom-Schutzeinrichtungen RCD - Residual Current Protective Device) zu verwenden.

Bei Anwendungen mit leistungsstarken Frequenzumrichterantrieben ist jedoch in dem besonders kritischen Fehlerfall, dem Erdschluss einer Motorphase, mit großen Gleichstromanteilen in dem Fehlerstrom zu rechnen. Der Einsatz einer Fehlerstrom-Schutzeinrichtung Typ A (zur Erkennung von Fehlerwechselströmen und pulsierenden Fehlergleichströmen) ist somit meist nicht möglich. Entsprechende geeignete Fehlerstrom-Schutzeinrichtungen Typ B (zur Erkennung von Fehlerwechselströmen, pulsierenden Fehlergleichströmen und reinen Fehlergleichströmen) für leistungsstarke Frequenzumrichterantriebe sind häufig nicht verfügbar.

Allerdings ist der Einsatz von Differenzstrom-basierten Schutzeinrichtungen in ungeerdeten Stromversorgungssystemen grundsätzlich problematisch, da diese Art der Schutzeinrichtung nur zuverlässig funktioniert, wenn sichergestellt ist, dass sich der Differenzstromwandler der Fehlerstrom-Schutzeinrichtung auch tatsächlich in der Fehlerschleife befindet.

Die Offenlegungsschrift EP 2 230 522 A1 zeigt ein Verfahren und eine Vorrichtung zur Isolationsüberwachung eines Gleichstrom-IT-Netzes, das über einen galvanisch verbundenen Wechselrichter an ein geerdetes Wechselstromnetz gekoppelt ist. Zur Bestimmung des Isolationswiderstands ist eine Widerstandsmesseinrichtung vorgesehen, die über einen Umschalter einen Referenzwiderstand wechselweise mit den Leitern des Gleichstrom-IT-Netzes verbindet. Mit einer zusätzlichen Strommesseinrichtung auf der Gleichstromseite kann ein über den laufenden Wechselrichter fließender Ableitstrom detektiert werden.

In EP 2 490 032 A2 ist ein Verfahren zur Erkennung von Erdschlüssen in einem Motorantriebssystem mit einem Umrichter offenbart. Dabei wird das Antriebssystem mit einer Gleichtaktspannung beaufschlagt, um Motorsteuersignale zu erzeugen, die eine eindeutige Identifizierung von Fehlerströmen ermöglichen.

In EP 2 219 041 A1 ist eine robuste Erkennung eines Wechselstromfehlerstromes in einem Elektrofahrzeug mittels Seitenbandharmonischen eines pulsweitenmodulierten Signals beschrieben.

Die EP 1 229 629 A2 zeigt eine Vorrichtung und ein Verfahren zur Erdschlusserkennung für ein Solarstromerzeugungssystem. Dabei wird ein Differenzstrom zwischen den Ausgangsleitungen einer Solarbatterie erkannt, eine auf die Kapazität der Solarbatterie gegenüber Erde zurückzuführende Wechselstrom-Leckstromkomponente aus dem Differenzstrom entfernt und durch Vergleichen eines Stromwerts nach Entfernung der Wechselstrom-Leckstromkomponente mit einem vorgegebenen Schwellenwert ermittelt, ob ein Erdschlusszustand aufgetreten ist.

In EP 2 530 801 A1 wird ein Fehlerstrom-Schutzsystem zur störresistenten Bestimmung des Erdschluss-Fehlerwiderstands in durch Systemrauschen beeinträchtigten elektrischen Anlagen beschrieben. Das Messverfahren beruht auf der Einspeisung einer Messsignalspannung, deren Frequenz adaptiv in Abhängigkeit eines gemessenen Rauschspektrums eingestellt wird.

Die Forderung nach kurzen Mess- und Abschaltzeiten, die in speziellen Anwendungsfällen geboten ist, kann nach dem Stand der Technik nicht vollumfänglich erfüllt werden.

Der vorliegenden Erfindung liegt somit die Aufgabe zu Grunde, ein Verfahren und eine Vorrichtung für eine störresistente Isolationsüberwachung in einem ungeerdeten Stromversorgungssystem mit einem Umrichterantrieb anzugeben.

Die der Erfindung zugrunde liegende Aufgabe wird gelöst durch Anlegen einer Messspannung zwischen einen aktiven Leiter des Stromversorgungssystems und Erde und Erfassen eines von der Messspannung getriebenen Messsignals, Nachbilden eines Pulsweitenmodulations-Signals des Umrichters, Bewerten des nachgebildeten Pulsweitenmodulations-Signals mit Filtercharakteristiken, die einer Filterung des erfassten Messsignals entsprechen, um ein niederfrequentes Störsignal zu erhalten und Subtrahieren des niederfrequenten Störsignals von dem erfassten Messsignal.

Mit dieser Vorgehensweise wird eine Störresistenz bei der Isolationsüberwachung gegenüber von dem Umrichter erzeugten niederfrequenten Störanteilen dadurch erzielt, dass diese niederfrequenten Störanteile so weit unterdrückt werden, dass eine (Frequenz-) lückenlose Überwachung des Isolationswiderstands möglich ist. Damit können auch symmetrische Fehler bei niederfrequenten Störungen schnell und genau erfasst werden.

Im Unterschied zu den oben beschriebenen schaltfrequenten Störanteilen entstehen störende niederfrequente Anteile in der Verlagerungsspannung eines ungeerdeten Stromversorgungsystems mit einem Umrichterantrieb durch die in dem Umrichter zur Generierung von Ansteuersignalen verwendete Pulsbreitenmodulation (PWM). Diese Störanteile können Amplituden in Höhe der Zwischenkreisspannung des Frequenzumrichters aufweisen.

Anstelle der aus dem Stand der Technik bekannten, langsam einschwingenden analogen und/oder digitalen Filter zur Eliminierung der schaltfrequenten Störanteile wird Systemwissen über den die störenden niederfrequenten Anteile verursachenden Frequenzumrichter zur Nachbildung des Pulsweitenmodulations-Signals (PWM-Signals) genutzt. Als zugängliche, interne Systemgrößen des Umrichters können beispielsweise die Frequenz und das Tastverhältnis des Pulsweitenmodulations-Signals oder die Amplitude der Zwischenkreis-Gleichspannung verwendet werden.

Das Pulsweitenmodulations-Signal des Frequenzumrichters wird aus dem vorhandenen Systemwissen rekonstruiert und mit den gleichen Filtercharakteristiken bewertet, die einer Filterung des erfassten Messsignals entsprechen. Um ein niederfrequentes Störsignal zu erhalten, werden somit auf das nachgebildete Pulsweitenmodulations-Signal genau die Filteralgorithmen angewendet, die auch das zur Isolationsüberwachung erfasste Messsignal in einem Isolationsüberwachungsgerät durchläuft.

Das so gewonnene niederfrequente Störsignal wird dann von dem erfassten Messsignal, welches als Mischsignal sowohl einen Nutzanteil - aufgrund der angelegten Messspannung - als auch den durch den Umrichterantrieb verursachten Störanteil beinhaltet, subtrahiert, um ein von den niederfrequenten Störungen befreites Messsignal zur Ermittlung des Isolationswiderstands zu erhalten.

Ist zusätzlich noch die Modulationsart (z.B. Block- oder Sinuskommutierung) des Frequenzumrichters bekannt, so kann das PWM-Signal des Frequenzumrichters ohne Kenntnis weiterer Signalanteile wie Netzfrequenz oder Messsignal nachgebildet werden.

Die Bewertung des nachgebildeten Pulsweitenmodulations-Signals mit den gleichen Filteralgorithmen, die in einem Isolationsüberwachungsgerät auf das erfasste Messsignal angewendet werden - vorzugsweise eine Filterung mit Tiefpass-Charakteristik -, extrahiert die gewünschten niederfrequenten Störanteile, die der Frequenzumrichter verursacht.

Wird dieses niederfrequente Störsignal von dem erfassten Messsignal in dem Isolationsüberwachungsgerät subtrahiert, so ist eine deutliche Störunterdrückung erreichbar. Auf diese Weise ist in einem ungeerdeten Stromversorgungssystem mit einem Umrichter eine normgerechte, schnell arbeitende und vor allem im niederfrequenten Bereich störresistente Isolationsüberwachung in allen Betriebszuständen des Umrichters möglich, ohne dass eine Überwachungslücke in niederfrequenten Bereichen entsteht.

Der erfindungsgemäße Verzicht auf eine Selektion der niederfrequenten Störung aus dem erfassten Messsignal durch aufwändige und/oder langsame Filteralgorithmen ermöglicht, dass die Störunterdrückung deutlich schneller arbeitet - und das auch in Fällen, wo die Frequenzen von Störsignal und Messsignal nahe beieinander liegen.

In weiterer Ausgestaltung werden eine Frequenz und ein Tastverhältnis des Pulsweitenmodulations-Signals über eine digitale Schnittstelle von dem Umrichter bereitgestellt oder können alternativ mit Methoden der Signalverarbeitung berechnet werden.

Die Frequenz und das Tastverhältnis des Pulsweitenmodulations-Signals können dabei direkt von dem Frequenzumrichter beispielsweise über eine digitale Schnittstelle zur Verfügung gestellt werden oder über sehr schnelle regelungstechnische Verfahren aus der Nachrichtentechnik berechnet werden (z.B. PLL-Schaltung).

Weiterhin wird eine Amplitude des Pulsweitenmodulations-Signals als eine Amplitude einer Zwischenkreis-Gleichspannung des Umrichters unmittelbar vorgegeben oder messtechnisch ermittelt.

Vorzugsweise erfolgt die messtechnische Ermittlung der Amplitude des Pulsweitenmodulations-Signals durch eine Gleichspannungsmessung an dem Zwischenkreis des Umrichters oder durch eine Leiterspannungsmessung mit einem Korrekturfaktor.

Die messtechnische Ermittlung kann dabei als Gleichspannungsmessung an dem Zwischenkreis des Umrichters erfolgen oder über eine Messung der Phase-Phase-Spannung unter Verwendung eines bekannten Korrekturfaktors ermittelt werden. Häufig gilt dabei der Zusammenhang Uzwk = (1.32 ... 1.4) Un, mit der Zwischenkreis-Gleichspannung Uzwk, der Netznennspannung Un und dem Korrekturfaktur zwischen 1.32 und 1.4.

Die der Erfindung zugrunde liegende Aufgabe wird weiter gelöst durch eine elektrische Schaltungsanordnung mit einer Ankopplungseinrichtung zum Anlegen einer Messspannung zwischen einen aktiven Leiter des Stromversorgungssystems und Erde und zur Erfassung eines von der Messspannung getriebenen Messsignals, mit einer Rekonstruktionseinheit zum Nachbilden eines Pulsweitenmodulations-Signals des Umrichters, mit einer Bewertungsschaltung zum Bewerten des nachgebildeten Pulsweitenmodulations-Signals, wobei die Bewertungsschaltung Filtercharakteristiken aufweist, die einer Filterung des erfassten Messsignals entsprechen, um ein niederfrequentes Störsignal zu erhalten und mit einer Subtraktionsschaltung zum Subtrahieren des niederfrequenten Störsignals von dem erfassten Messsignal.

Zur Ausführung des erfindungsgemäßen Verfahrens weist die erfindungsgemäße elektrische Schaltungsanordnung als wesentliche Funktionsblöcke eine Ankopplungseinrichtung zum Anlegen einer Messspannung, eine Rekonstruktionseinheit zum Nachbilden eines Pulsweitenmodulations-Signals, eine Bewertungsschaltung zum Bewerten des nachgebildeten Pulsweitenmodulations-Signals sowie eine Subtraktionsschaltung zum Subtrahieren des niederfrequenten Störsignals von dem erfassten Messsignal auf.

Mit dieser Schaltungsanordnung wird in der Rekonstruktionseinheit das Pulsweitenmodulations-Signal des Umrichters nachgebildet und in der Bewertungsschaltung Tiefpass-gefiltert. Das so modellierte Signal entspricht dem vom Umrichter erzeugten niederfrequenten Störsignal und wird in der Subtraktionsschaltung von dem erfassten Messsignal subtrahiert um ein von niederfrequenten Störanteilen befreites Messsignal zu erhalten.

In weiterer Ausgestaltung umfasst die elektrische Schaltungsanordnung eine digitale Schnittstelle, über die eine Frequenz und ein Tastverhältnis des Pulsweitenmodulations-Signals von dem Umrichter bereitgestellt werden.

Alternativ kann die elektrische Schaltungsanordnung eine Recheneinheit zur Berechnung einer Frequenz und eines Tastverhältnisses des Pulsweitenmodulations-Signals mit Methoden der Signalverarbeitung umfassen.

Mit Vorteil umfasst das Isolationsüberwachungsgerät zur Überwachung eines Isolationswiderstands in einem ungeerdeten Stromversorgungssystem mit einem Umrichter eine erfindungsgemäße elektrische Schaltungsanordnung für eine störresistente Isolationsüberwachung, welche das Pulsweitenmodulations-Signal des Umrichters nachgebildet und das daraus gewonnene niederfrequente Störsignal aus dem erfassten Messsignal eliminiert.

Durch diese Erweiterung des normgemäß vorgeschriebenen Isolations-überwachungsgerätes kann die Isolationsüberwachung auch bei Auftreten von niederfrequenten Störsignalen zuverlässig durchgeführt werden.

Weitere vorteilhafte Ausgestaltungsmerkmale ergeben sich aus der nachfolgenden Beschreibung und der Zeichnung, die eine bevorzugte Ausführungsform der Erfindung an Hand eines Beispiels erläutert. Es zeigt:

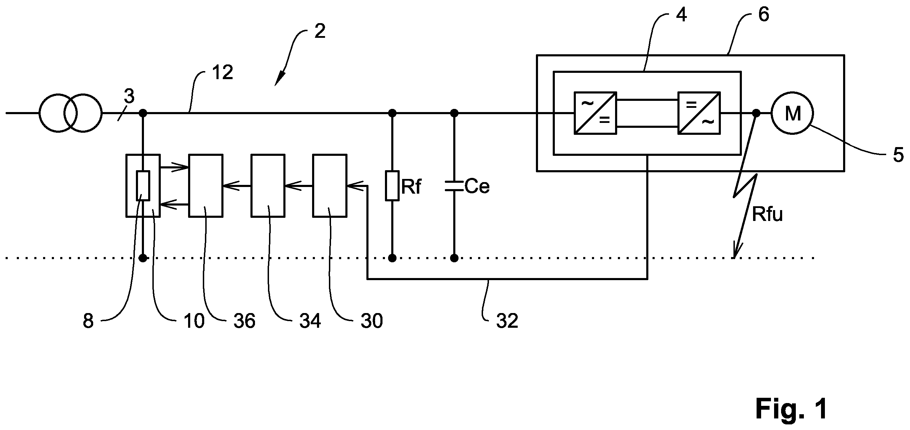

- **Fig. 1:**: eine Ausführungsform der erfindungsgemäßen Schaltungsanordnung mit Nachbilden eines Pulsweitenmodulations-Signals.

In **Fig. 1** ist in einem funktionalen Blockdiagramm eine erfindungsgemäße Schaltungsanordnung für eine störresistente Isolationsüberwachung eines ungeerdeten Stromversorgungssystems 2 mit einem Umrichter 4 dargestellt.

Diese Schaltungsanordnung bildet ein Pulsweitenmodulations-Signal des Umrichters 4 nach, um ein im niederfrequenten Bereich, vorzugsweise zwischen DC und ca. 15 Hz, störungsfreies Messsignal zu erhalten. Für ältere Isolationsüberwachungsgeräte kann dieser niederfrequente Bereich wegen der größeren Überwachungslücke DC bis 40 Hz betragen, aktuelle, hochwertige Isolationsüberwachungsgeräten reduzieren die Überwachungslücke von DC bis auf unter 1 Hz.

In dieser Ausführung umfasst die Schaltungsanordnung neben der in dem Isolationsüberwachungsgerät 10 angeordneten Ankopplungseinrichtung 8 eine Rekonstruktionseinheit 30, die das Pulsweitenmodulations-Signal des Umrichters 4 nachbildet. Dazu ist die Rekonstruktionseinheit 30 über eine digitale Schnittstelle 32 mit dem Umrichter 4 verbunden, um interne Systemgrößen des Umrichters wie Frequenz und Tastverhältnis des Pulsweitenmodulations-Signals direkt zur Nachbildung des Pulsweitenmodulations-Signals heranzuziehen.

Die Schaltungsanordnung weist weiterhin eine Bewertungsschaltung 34 auf, welche das nachgebildete Pulsweitenmodulations-Signal einer Filterung unterzieht, um ein niederfrequentes Störsignal zu erhalten, welches die von dem Umrichter 4 im Fehlerfall erzeugten Störanteile widerspiegelt. Die dabei verwendete Filtercharakteristik entspricht derjenigen, die auch in dem Isolationsüberwachungsgerät 10 zur Filterung des erfassten Messsignals eingesetzt wird.

In einer der Bewertungsschaltung 34 nachgelagerten Subtraktionsschaltung 36 wird das durch Filterung gewonnene niederfrequente Störsignal von dem erfassten Messsignal subtrahiert, sodass sich der in dem erfassten Messsignal enthaltene niederfrequente Störanteil und der aus dem rekonstruierten Pulsweitenmodulations-Signal gewonnene niederfrequente Störanteil einander kompensieren und ein im niederfrequenten Bereich weitgehend störungsfreies Messsignal zur Verfügung steht.

## Patentansprüche

1. Verfahren für eine störresistente Isolationsüberwachung eines ungeerdeten Stromversorgungssystems mit einem Umrichter (4), umfassend die Verfahrensschritte:
Anlegen einer Messspannung zwischen einen aktiven Leiter des Stromversorgungssystems und Erde und Erfassen eines von der Messspannung getriebenen Messsignals,
Nachbilden eines Pulsweitenmodulations-Signals des Umrichters (4), Bewerten des nachgebildeten Pulsweitenmodulations-Signals mit Filtercharakteristiken, die einer Filterung des erfassten Messsignals entsprechen, um ein niederfrequentes Störsignal zu erhalten,
Subtrahieren des niederfrequenten Störsignals von dem erfassten Messsignal.

2. Verfahren nach Anspruch 1,
**dadurch gekennzeichnet,**
**dass** eine Frequenz und ein Tastverhältnis des Pulsweitenmodulations-Signals über eine digitale Schnittstelle (32) von dem Umrichter (4) bereitgestellt werden.

3. Verfahren nach Anspruch 1,
**dadurch gekennzeichnet,**
**dass** eine Frequenz und ein Tastverhältnis des Pulsweitenmodulations-Signals mit Methoden der Signalverarbeitung berechnet werden.

4. Verfahren nach einem der Ansprüche 1 bis 3,
**dadurch gekennzeichnet,**
**dass** eine Amplitude des Pulsweitenmodulations-Signals als eine Amplitude einer Zwischenkreis-Gleichspannung des Umrichters (4) unmittelbar vorgegeben wird oder messtechnisch ermittelt wird.

5. Verfahren nach Anspruch 4,
**dadurch gekennzeichnet,**
**dass** die messtechnische Ermittlung der Amplitude des Pulsweitenmodulations-Signals durch eine Gleichspannungsmessung an dem Zwischenkreis des Umrichters (4) oder durch eine Leiterspannungsmessung mit einem Korrekturfaktor erfolgt.

6. Elektrische Schaltungsanordnung für eine störresistente Isolationsüberwachung eines ungeerdeten Stromversorgungssystems mit einem Umrichter (4),
mit einer Ankopplungseinrichtung (8) zum Anlegen einer Messspannung zwischen einen aktiven Leiter des Stromversorgungssystems und Erde und zur Erfassung eines von der Messspannung getriebenen Messsignals, mit einer Rekonstruktionseinheit (30) zum Nachbilden eines Pulsweitenmodulations-Signals des Umrichters (4), mit einer Bewertungsschaltung (34) zum Bewerten des nachgebildeten Pulsweitenmodulations-Signals, wobei die Bewertungsschaltung (34) Filtercharakteristiken aufweist, die einer Filterung des erfassten Messsignals entsprechen, um ein niederfrequentes Störsignal zu erhalten und mit einer Subtraktionsschaltung (36) zum Subtrahieren des niederfrequenten Störsignals von dem erfassten Messsignal.

7. Elektrische Schaltungsanordnung nach Anspruch 6,
**gekennzeichnet durch**
eine digitale Schnittstelle (32), über die eine Frequenz und ein Tastverhältnis des Pulsweitenmodulations-Signals von dem Umrichter (4) bereitgestellt werden.

8. Elektrische Schaltungsanordnung nach Anspruch 6,
**gekennzeichnet durch**
eine Recheneinheit zur Berechnung einer Frequenz und eines Tastverhältnisses des Pulsweitenmodulations-Signals mit Methoden der Signalverarbeitung.

9. Isolationsüberwachungsgerät (10) zur Überwachung eines Isolationswiderstands in einem ungeerdeten Stromversorgungssystem mit einem Umrichter (4),
**gekennzeichnet durch**
eine elektrische Schaltungsanordnung für eine störresistente Isolationsüberwachung nach einem der Ansprüche 6 bis 8.

## Claims

1. A method for an interference-resistant insulation monitoring of an ungrounded power supply system having a converter (4), the method comprising the following steps:
applying a measuring voltage between an active conductor of the power supply system and ground and detecting a measuring signal driven by the measuring voltage,
replicating a pulse width modulation signal of the converter (4), assessing the replicated pulse width modulation signal using filter characteristics corresponding to a filtering of the detected measuring signal in order to obtain a low-frequency interfering signal,
subtracting the low-frequency interfering signal from the detected measuring signal.

2. The method according to claim 1,
**characterized in that**
a frequency and a duty factor of the pulse width modulation signal are provided by the converter (4) via a digital interface (32).

3. The method according to claim 1,
**characterized in that**
a frequency and a duty factor of the pulse width modulation signal are calculated using signal processing methods.

4. The method according to any one of the claims 1 to 3,
**characterized in that**
an amplitude of the pulse width modulation signal is directly predetermined or metrologically determined as an amplitude of an intermediary-circuit direct voltage of the converter (4).

5. The method according to claim 4,
**characterized in that**
the amplitude of the pulse width modulation signal is metrologically detected via a direct voltage measurement at the intermediate circuit of the converter (4) or via a conductor voltage measurement having a correction factor.

6. An electrical circuit arrangement for an interference-resistant insulation monitoring of an ungrounded power supply system having a converter (4),
having a coupling device (8) for applying a measuring voltage between an active conductor of the power supply system and ground and for detecting a measuring signal driven by the measuring voltage; having a reconstruction unit (30) for replicating a pulse width modulation signal of the converter (4); having an assessment circuit (34) for assessing the replicated pulse width modulation signal, said assessment circuit (34) having filter characteristics corresponding to a filtering of the detected measuring signal in order to obtain a low-frequency interfering signal; and having a subtraction circuit (36) for subtracting the low-frequency interfering signal from the detected measuring signal.

7. The electrical circuit arrangement according to claim 6,
**characterized by**
a digital interface (32) via which a frequency and a duty factor of the pulse width modulation signal are provided by the converter (4).

8. The electrical circuit arrangement according to claim 6,
**characterized by**
a computing unit for computing a frequency and a duty factor of the pulse width modulation signal using signal processing methods.

9. An insulation monitoring device (10) for monitoring an insulation resistance in an ungrounded power supply system using a converter (4), **characterized by**
an electrical circuit arrangement for an interference-resistant insulation monitoring according to any one of the claims 6 to 8.

## Revendications

1. Procédé de surveillance d'isolement résistante aux interférences d'un système d'alimentation en courant non mis à la terre et ayant un convertisseur (4), le procédé comprenant les étapes suivantes :
appliquer un courant de mesure entre un conducteur actif du système d'alimentation en courant et la terre et détecter un signal de mesure induit par la tension de mesure,
reproduire un signal de modulation d'impulsions en durée du convertisseur (4),
évaluer le signal reproduit de modulation numérique d'impulsions en durée à l'aide de caractéristiques de filtrage correspondant à un filtrage du signal de mesure détecté afin d'obtenir un signal brouilleur à basse fréquence,
soustraire le signal brouilleur à basse fréquence du signal de mesure détecté.

2. Procédé selon la revendication 1,
**caractérisé en ce**
**qu'**une fréquence et un facteur d'utilisation du signal de modulation d'impulsions en durée sont fournis par le convertisseur (4) par l'intermédiaire d'une interface numérique (32).

3. Procédé selon la revendication 1,
**caractérisé en ce**
**qu'**une fréquence et un facteur d'utilisation du signal de modulation d'impulsions en durée sont calculés à l'aide d'un traitement de signaux.

4. Procédé selon l'une quelconque des revendications 1 à 3,
**caractérisé en ce**
**qu'**une amplitude du signal de modulation d'impulsions en durée est directement prédéterminée ou déterminée métrologiquement en tant qu'amplitude d'une tension continue du circuit intermédiaire du convertisseur (4).

5. Procédé selon la revendication 4,
**caractérisé en ce que**
l'amplitude du signal de modulation d'impulsions en durée est détectée métrologiquement par l'intermédiaire d'une mesure de tension continue au niveau du circuit intermédiaire du convertisseur (4) ou par l'intermédiaire d'une mesure de la tension de conducteur ayant un facteur de correction.

6. Dispositif de circuit électrique pour une surveillance d'isolement résistante aux interférences d'un système d'alimentation en courant non mis à la terre et ayant un convertisseur (4),
ayant un dispositif de couplage (8) destiné à appliquer un courant de mesure entre un conducteur actif du système d'alimentation en courant et la terre et pour détecter un signal de mesure induit par la tension de mesure ; ayant une unité de reconstruction (30) destiné à reproduire un signal de modulation d'impulsions en durée du convertisseur (4) ; ayant un circuit d'évaluation (34) destiné à évaluer le signal reproduit de modulation numérique d'impulsions en durée, ledit circuit d'évaluation (34) ayant des caractéristiques de filtrage correspondant à un filtrage du signal de mesure détecté afin d'obtenir un signal parasite à basse fréquence ; et ayant un circuit de soustraction (36) destiné à soustraire le signal brouilleur à basse fréquence du signal de mesure détecté.

7. Dispositif de circuit électrique selon la revendication 6,
**caractérisé par**
une interface numérique (32) par l'intermédiaire de laquelle une fréquence et un facteur d'utilisation du signal de modulation d'impulsions en durée sont fournis par le convertisseur (4).

8. Dispositif de circuit électrique selon la revendication 6,
**caractérisé par**
une unité de calcul destiné à calculer une fréquence et un facteur d'utilisation du signal de modulation d'impulsions en durée à l'aide de procédés de traitement de signaux.

9. Dispositif (10) de surveillance d'isolement pour la surveillance d'une résistance d'isolement dans un système d'alimentation en courant non mis à la terre et ayant un convertisseur (4),
**caractérisé par**
un agencement de circuit électrique pour une surveillance d'isolement résistante aux interférences selon l'une quelconque des revendications 6 à 8.
